# EUROPEAN PATENT SPECIFICATION

(11) **EP 4 261 693 B1**
(45) Date of publication and mention of the grant of the patent: **09.12.2026**
(21) Application number: 23161676.4
(22) Date of filing: 14.03.2023
(51) Int. Cl.: G06F 12/02, G06F 12/10

(54) **A METHOD OF MANAGING MEMORY IN AN INTEGRATED CIRCUIT CARD AND CORRESPONDING INTEGRATED CIRCUIT CARD**
VERFAHREN ZUR VERWALTUNG DES SPEICHERS IN EINER CHIPKARTE UND ENTSPRECHENDE CHIPKARTE
PROCÉDÉ DE GESTION DE MÉMOIRE DANS UNE CARTE A CIRCUIT INTÉGRÉ ET CARTE A CIRCUIT INTÉGRÉ CORRESPONDANTE

(30) Priority: 15.04.2022 IT 202200007676
(43) Date of publication of application: 18.10.2023
(73) Proprietor: STMicroelectronics S.r.l., 20864 Agrate Brianza (MB) (IT)
(72) Inventor: VENEROSO, Amedeo, 81100 Caserta (IT); CIMINO, Carlo, 80128 Napoli (IT)
(74) Representative: Buzzi, Notaro & Antonielli d'Oulx S.p.A.

(56) References cited:
- US-A1- 2007 011 660
- US-B1- 7 039 774
- MIN-SIK JIN ET AL: "A Study on Fast JCVM with New Transaction Mechanism and Caching-Buffer Based on Java Card Objects with a High Locality", 1 January 2005, SAT 2015 18TH INTERNATIONAL CONFERENCE, AUSTIN, TX, USA, SEPTEMBER 24-27, 2015; [LECTURE NOTES IN COMPUTER SCIENCE; LECT.NOTES COMPUTER], SPRINGER, BERLIN, HEIDELBERG, PAGE(S) 91 - 100, ISBN: 978-3-540-74549-5, XP019025373
- KEVIN MARQUET ET AL: "An object memory management solution for small devices with heterogeneous memories", INTELLIGENT SOLUTIONS IN EMBEDDED SYSTEMS, 2007 FIFTH WORKSHOP ON, IEEE, PI, 1 June 2007 (2007-06-01), pages 227 - 237, XP031194304, ISBN: 978-84-89315-47-1
- ANONYMOUS: "RuimTools: JavaCard best programming guidelines", 2 April 2022 (2022-04-02), XP055981682, Retrieved from the Internet <URL:https://web.archive.org/web/20220402084336/http://ruimtools.com/doc.php?doc=jc_best> [retrieved on 20221115]
- YOON-SIM YANG ET AL: "An Advanced Java Card System Architecture for Smart Card Based on Large RAM Memory", HYBRID INFORMATION TECHNOLOGY, 2006. ICHIT '06, IEEE, PISCATAWAY, NJ, USA, 9 November 2006 (2006-11-09), pages 646 - 650, XP032070235, ISBN: 978-0-7695-2674-4, DOI: 10.1109/ICHIT.2006.253676

## Description

### Technical Field

Embodiments of the present disclosure relate to techniques of managing memory in an integrated circuit card using a Java Card platform, said integrated circuit card comprising a non-volatile memory portion and a RAM memory portion, comprising allocating one or more transient arrays in the RAM memory portion allocating a corresponding memory area value, introducing corresponding array pointers in a non-volatile memory heap.

Embodiments of the present disclosure relate in particular to multi applicative and/or multi profile card, such as secure elements, telecom cards, banking cards.

### Background

Universal Integrated Circuit Cards (UICCs), often referred as Subscriber Identity Module (SIM) card, are widely used to enable the mobile devices to access services provided by Mobile Network Operators (MNOs).

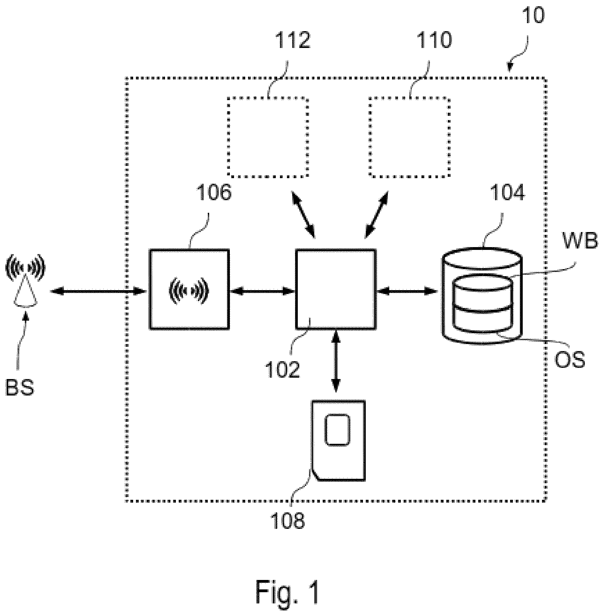

In this context, Figure 1 shows a possible architecture of a "user equipment" 10, such as a mobile device, e.g. a smartphone or a tablet, or a mobile communication module usually to be used in embedded systems.

Generally, the device 10 comprises one or more processors 102 connected to one or more memories 104. The device 10 comprises moreover at least one mobile communication interface 106 for communication with a base station BS.

For example, the mobile communication interface 106 may comprise a GSM (Global System for Mobile Communications), CDMA (Code Division Multiple Access) transceiver, W-CDMA (Wideband Code Division Multiple Access), UMTS (Universal Mobile Telecommunications System), HSPA (High-Speed Packet Access) and/or LTE (Long Term Evolution) transceiver.

A mobile device comprises often also a user interface 110, such as a touchscreen. Conversely, a communication module to be used, e.g., in embedded systems, such as alarm systems, gas meters or other types of remote monitoring and/or control systems, often does not comprise a user interface 110, but a communication interface 112 in order to exchange data with a further processing unit of an embedded system. For example, in this case, the interface 112 may be a digital communication interface, such as a UART (Universal Asynchronous Receiver-Transmitter), SPI (Serial Peripheral Interface) and/or USB (Universal Serial Bus) communication interface. Generally, the processing unit 102 may also be directly the main processor of an embedded system. In this case the interface 112 may be used to exchange data with one or more sensors and/or actuators. For example, in this case, the interface 112 may be implemented by means of one or more analog interfaces and/or digital input/output ports of the processing unit 102.

In the memory 104 may be stored e.g. an operating system OS being executed by the processor 102 and which manages the general functions of the device 10, such as the management of the user interface 110 and/or the communication interface 112 and the establishment of a connection to the base station BS via the interface 106. The memory 104 may also contain applications being executed by the operating system OS. For example, in the case of a mobile device, the memory 104 often comprises a web browser application WB.

For establishing a connection with the base station BS, the device 10 is coupled to a processing unit 108 configured to manage the identity identification of the user. For example, usually a mobile device comprises a card holder for receiving a card comprising a Subscriber Identity Module (SIM), which is usually called SIM card. Generally a corresponding SIM module may also be installed directly within the device 10. In the example of Figure 1 it is used a Universal Integrated Circuit Card (UICC) 108, which is a smart card often used in GSM and UMTS networks. The UICC ensures the integrity and security of all kinds of personal data and typically holds a few hundred kilobytes. Also a UICC may be integrated directly in the device 10 and is in this case often called embedded UICC (eUICC).

For example, in a GSM network, the UICC 108 contains a SIM application and in a UMTS network a USIM application. A UICC may contain several applications, making it possible for the same smart card to give access to both GSM and UMTS networks, and may also provide storage of a phone book and other applications.

Accordingly, the reference to a SIM module in the following of the present description is intended to include modules for the above network and applies also the case in which such a SIM module is provided on a SIM card.

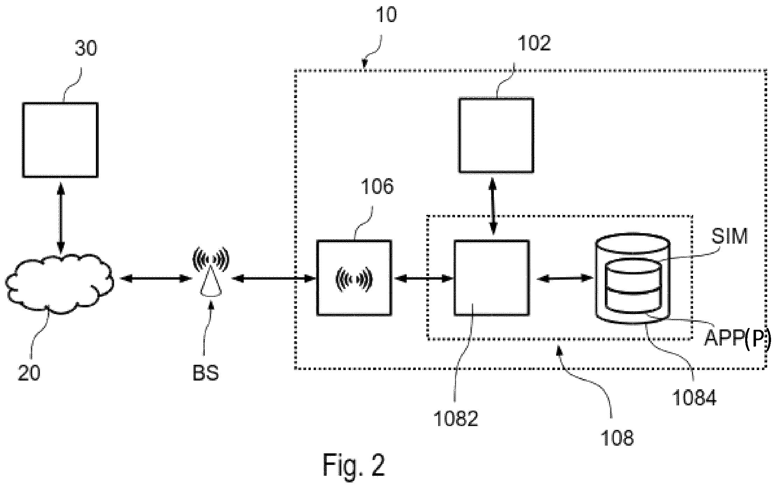

As shown in Figure 2, a SIM module 108 often comprises one and more processors 1082 and one or more memories 1084 for executing applications stored in the memory 1084 of the module 108. For example, the SIM module 108 may comprise in addition to the Subscriber Identity Module application (reference sign SIM in Figure 2) at least one further application APP. For example, this application APP may be configured to communicate (directly, or indirectly via the processor 102 and possibly the operating system OS) with the mobile communication interface 106 in order to send data to and/or receive data from a remote host 30. For this purpose, the host 30 may be connected via a network 20, such as a Local Area Network (LAN) or a Wide Area Network (WAN), such as the internet, to the base station BS. Accordingly, connection between the host 30 and the UICC 108 may be established by means of the network 20, the base station BS and the communication interface 108. Generally, the communication may be initiated by the host 30 or the UICC 108. For example, the application APP may be a web server application, which receives requests from the web browser WB of a mobile device 10 and obtains respective content from a remote host 30, such as a web server. The application APP may also be an authentication application. In this case, the host 30 may send an authentication request to the UICC 108 and the UICC 108 may send an authentication response to the host 30. The memory or a plurality of memories 1084 can be used also to store data images comprising the profile or the profiles pertaining different MNOs and operating systems related to the image. For image is here intended a structured representation of binary information, which is also encrypted, which is also configured to decrypt encapsulated data, manage rights and check the integrity of loaded decrypted data.

Thus, a UICC card in short usually comprises a microprocessor and a memory, typically including a non-volatile and a volatile portion. Such memory is configured to store data such as an operating system, applets and an MNO profile that a mobile device can utilize to register and interact with an MNO. The UICC can be removably introduced in a slot of a device, i.e. a mobile device, or they can also be embedded directly into the devices, in this case they are called eUICC.

Under this view, volatile memory, specifically RAM (Random Access Memory), is today the rarest resource on the integrated circuit card, in particular UICC (Universal Integrated Circuit Card) or embedded UICC. Typically the RAM resource is the first that is depleted. This implies that an efficient management of the volatile memory is necessary

Applications in integrated circuit cards are typically Java Card applications, i.e. the Java platform for integrated cards.

The Java Card platform presents some drawback regarding the RAM resources. One is that RAM is typically allocated at application installation. RAM can be of two types, clear on reset and clear on deselect, where Clear On Deselect (CoD) is not practical in Telecom toolkit application, while Clear On Reset (CoR) is virtually always available.

RAM allocation and deallocation in Java Card is slow.

Arrays in Java Card are by default stored in flash (e.g. storing an array a as a=new byte[20]) unless specific APIs are used (e.g., by the Java Card method JCSystem.makeTransientByteArray) which allows to allocate transient byte arrays in the RAM. Transient array data is lost (more precisely in an undefined state, but the real data is unavailable) immediately upon power loss, and is reset to the default value at the occurrence of certain events such as card reset or deselect. Updates to the values of transient arrays are not atomic and are not affected by transactions. Such transient arrays are not fully transient, this meaning that the object header is stored in a non-volatile memory of the card, specifically a flash memory. Thus, the flash header in the non-volatile memory points to the object RAM body, i.e. transient byte array, in the RAM.

The arrays - like all Java Card objects - are always present and they are de-allocated when no other object or variable references to it, e.g. are "unreachable" objects. As mentioned above this means that are in an undefined state, the data being unavailable.

To understand if an object is "unreachable" it is thus needed to scan the other objects to verify if someone refers it.

The operation of cancellation, in addition, may be quite slow because it requires the update in the non-volatile memory, i.e. flash, memory of the header and also of other headers if defragging is needed. Because of this slow dynamic, arrays are allocated at installation time and never deallocated

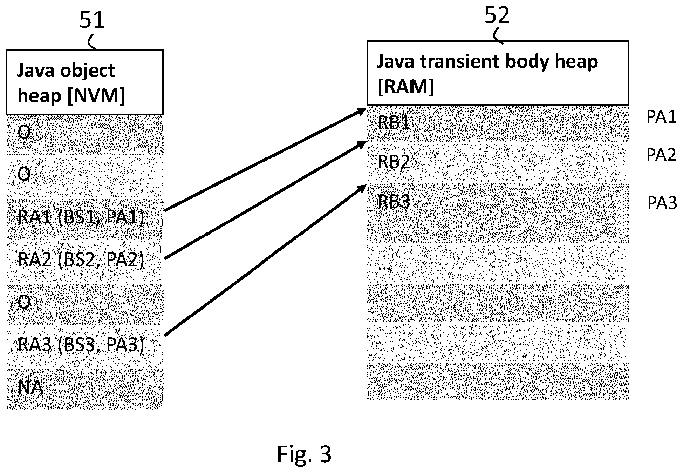

These operations are exemplified in figure 3, where it is shown schematically a Java object heap 51, which is stored in a non-volatile memory portion of the memory 1084 of the card 108 implementing Java Card, this last not shown. The heap space of the Java object heap 51 is used for the dynamic memory allocation of Java objects and JRE classes at runtime. New objects are always created in heap space, and the references to these objects are stored in stack memory. This memory, in contrast to stack, is not automatically deallocated. It needs a Garbage Collector to free up unused objects so as to keep the efficiency of the memory usage. Garbage Collector attempts to reclaim memory which was allocated by the program, but is no longer referenced The Java object heap 51 comprises objects O some of which are RAM array pointers RA, and NVM arrays NA. Specifically are indicated a first RAM array pointer RA1, a second RAM array pointer RA2 and a third RAM array pointer RA3.

With 52 is indicated a Java transient body heap stored in the RAM memory portion of the memory 1084 of the card 108 using Java Card, which stores three array bodies, RB1 (e.g. size 200 bytes), RB2 (e.g. size 40 bytes) and RB3 (e.g. size 5000 bytes). The RAM array pointers RA1, RA2, RA3 point (as indicated by the arrows) to the respective array bodies RB1, RB2, RB3, in particular to their physical address in the RAM Java transient body heap 52.

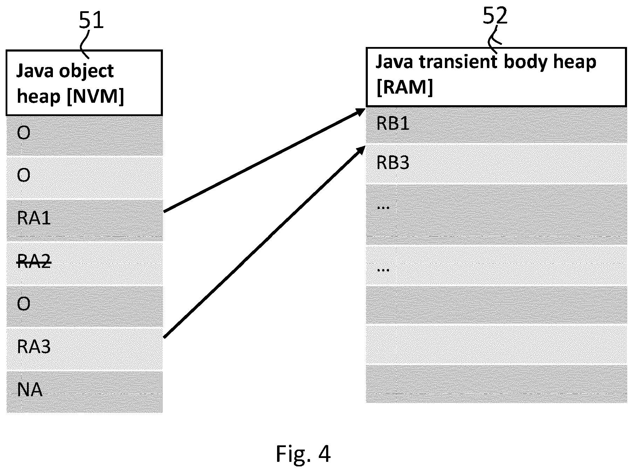

Figure 4 depicts schematically the situation in which an array body, specifically the second array body RB2 in the example, is removed from the Java transient body heap 52 stored. After the Garbage Collector is operated, the corresponding RAM array pointer RA2 is deleted.

Thus, in known solutions, the array pointer, or header, RA in the Java object heap 51 in the non-volatile portion of memory 1084 contains at least the following information:
- an indication of the corresponding array body RB size, BS (BS1, BS2, BS3 for the three pointer RA1, RA2, RA3 in the example), which is the size of the area of RAM memory assigned to the array body RB to contain the values of the array, and
- a body RB physical address PA (PA1, PA2, PA3 for the three pointer RA1, RA2, RA3 in the example), which is the address of the memory areas assigned in the Java transient body heap 52 to the array body RB to contain the values of the array body RB. When the applet or application calls the Java Card method JCSystem.makeTransient...Array, the operative system assigns an area of the Java transient body heap 52 in the RAM portion of memory 1084 and saves its address in the array pointer RA of the array body RB. That area of the memory remains assigned to that array body RB until it is deleted (freeing the memory which was reserved to it both in the object heap 51 in the non-volatile memory 104 and the Java transient body heap 52 in the RAM.

Thus a first solution is represented by managing at application level by means of creating the arrays when necessary and delete them when no more necessary, relying on the Java Card garbage collector

As indicated, this solution is slow.

A different solution may involve managing at application level by means of reusing of resources. This is quite complex and error prone and the same memory cannot be shared with applets of other packages due to the Java Card firewall,

Also it is possible to manage at application level by means of using proprietary APIs to allocate/deallocate memory. This also may be slower and in addition applets need to be customized for the platform supporting them.

Documents US 7 039 774 B1, US 2007/011660 A1, Min-Sik Jin et al. "A Study on Fast JCVM with New Transaction Mechanism and Caching-Buffer Based on Java Card Objects with a High Locality", ISBN:978-3-540-74549-5, *"*An object memory management solution for small devices with heterogeneous memories", ISBN:978-84-89315-47-1, Anonymous "RuimTools: JavaCard best programming guidelines", available at URL https://web.archive.org/web/20220402084336/http://ruimt ools.com/doc.php?doc=jc best, Yoon-Sim Yang et al. "An Advanced Java Card System Architecture for Smart Card Based on Large RAM Memory", ISBN:978-0-7695-2674-4, are also pertinent tc the technological background previously discussed.

### Summary

On the basis of the foregoing description, the need is felt for solutions which overcome one or more of the previously outlined drawbacks.

According to one or more embodiments, such an object is achieved through a method having the features specifically set forth in the claims that follow. Embodiments moreover concerns a related integrated circuit card.

The claims are an integral part of the technical teaching of the disclosure provided herein.

As mentioned in the foregoing, the present disclosure provides solutions regarding a method of managing memory in an integrated circuit card using a Java Card platform, said integrated circuit card comprising a non-volatile memory portion and a RAM memory portion, said method comprising a procedure for the allocation of one or more transient arrays in said RAM memory portion, said procedure comprising
creating in a non-volatile memory heap one or more array pointers, corresponding to one or more transient arrays to be allocated, each array pointer comprising a transient array size and a transient array address,
wherein
said creating operation comprises
creating one or more array pointers comprising as transient array address an address pointing indirectly to an area of the RAM memory portion in which the respective transient array is to be allocated, in particular a logical or indirect address,
said procedure further comprising
assigning then in said RAM memory area memory only to transient arrays, corresponding to said respective one or more array pointers, which comprise at least a value different from zero.

In variant embodiments, said creating one or more array pointers comprises creating said one or more array pointers with a required body size and writing a null value as transient array address which is a body logical address,
said assigning then in said RAM memory area memory only to transient arrays, corresponding to said respective one or more array pointers, which comprise at least a value different from zero comprising, when writing a value different from zero in any point of an array body, assigning an area of the RAM memory, with the size indicated in the body size, to the corresponding transient array and saving its address in said logical address of the corresponding array pointe.

In variant embodiments, the method comprises providing an indirection table, stored in the RAM memory, comprising reference addresses pointing to physical locations of respective arrays in the RAM memory and to which said RAM array pointers in the non-volatile memory, comprising a transient array address ordinately point.

In variant embodiments, said array pointer comprises as transient array address a logical address which comprises a null value or an address of the memory area containing said indirection table in the RAM memory, comprising a corresponding reference address which in its turn contains the physical address of the RAM memory assigned to the array.

In variant embodiments, said method comprises deallocating in said RAM memory transient arrays which values are all equal to zero.

In variant embodiments, said method comprises storing in said logical address either an address of the memory area assigned to the to the array body or a null value.

In variant embodiments, said deallocating comprises, when the transient array in the RAM memory is filled with zeroes writing in the logical address of the corresponding array pointer a zero value.

In variant embodiments, said procedure for the allocation of one or more transient arrays in said RAM memory portion comprising performing a Java Card method making transient arrays.

In variant embodiments, said method comprises applying a checking rule, checking if a memory values representing the sum of the size of all the created arrays is greater than a memory value representing the total physical memory in the RAM memory increased by a safety amount which is function of a settable parameter value, in particular multiplied or summed by such settable parameter value, and in the affirmative signalling an out of memory event

In variant embodiments, said method comprises performing said checking upon an application selection and, if an out of memory event occurs, requesting the failure of the selection.

The present disclosure also provides solutions regarding an integrated circuit card, in particular an eUICC, configured to perform the operations of the method managing memory in an integrated circuit card according to embodiments.

### Brief description of the figures

Embodiments of the present disclosure will now be described with reference to the annexed drawings, which are provided purely by way of non-limiting example and in which:
- Figures 1 to 4 have already been described in the foregoing;
- Figures 5A-5D show schematically operations of the method according to embodiments
- Figure 6 is a schematic illustrative of a variant of the method according to embodiments;
- Figure 7 is a flow diagram of the method according to embodiments.
- Figure 8 is a flow diagram of the variant of the method according to embodiments.

### Detailed Description

In the following description, numerous specific details are given to provide a thorough understanding of embodiments. The embodiments can be practiced without one or several specific details, or with other methods, components, materials, etc. In other instances, well-known structures, materials, or operations are not shown or described in detail to avoid obscuring aspects of the embodiments.

Reference throughout this specification to "one embodiment" or "an embodiment" means that a particular feature, structure, or characteristic described in connection with the embodiment is included in at least one embodiment. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

The headings provided herein are for convenience only and do not interpret the scope or meaning of the embodiments.

Figures parts, elements or components which have already been described with reference to previous figures are denoted by the same references previously used in such Figures; the description of such previously described elements will not be repeated in the following in order not to overburden the present detailed description.

The solution here described is based on the observation that arrays are allocated at installation, although some of them may not be used during the card session. More specifically, the arrays are initialized at an initialization value of zero or "0" bytes, when the card is reset, i.e. a CLEAR_ON_RESET is performed, and for some arrays such initialization value may remain "0" until the next card session, i.e. the RAM memory space remain unused.

The solution here described provides actually storing in the RAM, i.e. assigning RAM memory area to the array, only the arrays that have a body value different from all "0".

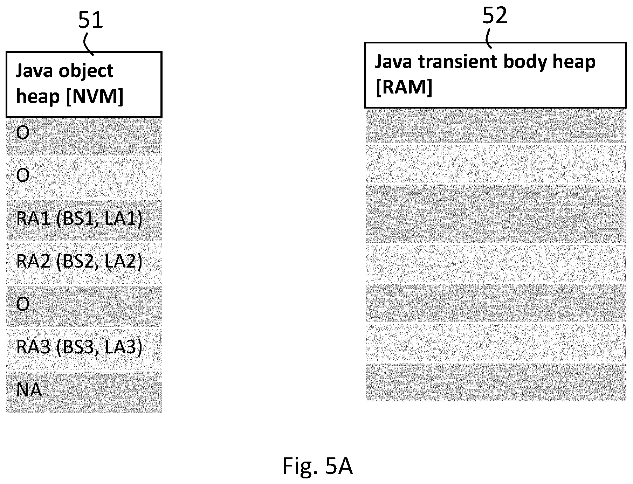

To this regard, Figure 5A depicts a first phase according to an embodiment of the method here described in which the Java transient body heap 52 initially contains no array body RB, even if they are created (e.g. a JCSystem.MakeTransient...Array method has been invoked), while the Java object heap 51 comprises RAM array pointers RA1, RA2, RA3. Such array pointers RA1, RA2, RA3 are in this first phase only headers to which it does not correspond an array body in the heap 52. They are created by a Java Card method for making transient array, e.g. the MakeTransient...Array. The dots '...' indicate the type of Array (Boolean, Bytes, Short, Object), which creates array pointers RA1, RA2, RA3 which point to a logic address, instead of a physical address, and define a size of the transient array RB1, RB2, RB3. Thus, in the first phase the transient arrays are virtually defined, but they are not physically stored in the RAM 52.

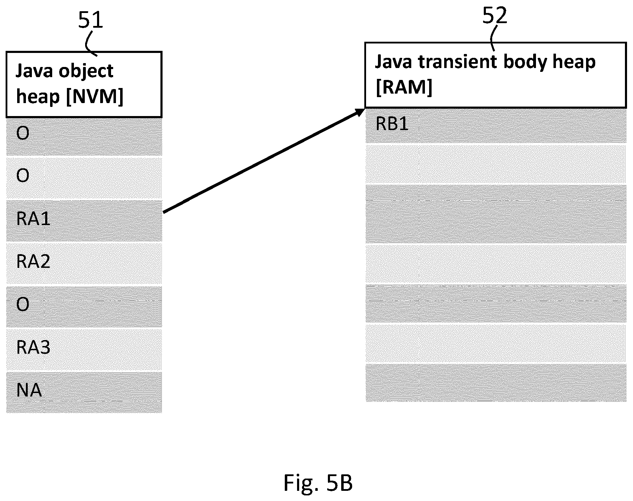

Figure 5B depicts a second phase in which, at a first writing, for instance by an application, of a value different from zero in a first array, e.g., a first array body RB1, such first array body RB1 is allocated in the RAM, namely in the Java transient body heap 52, the allocation being performed by transforming the logical address in a RAM array pointer RA1 in a physical address which points to an area memory in the heap 52 which is assigned to the first array body RB1, i.e. a transient array RB1 is stored in the RAM.

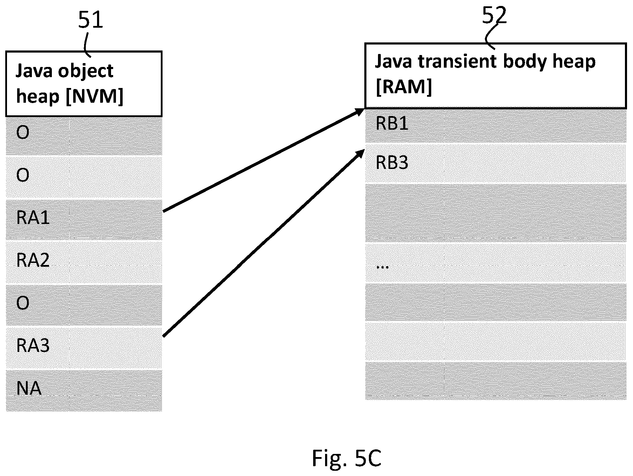

Figure 5C depicts a third phase of the method here described in which when, then a third array body RB3 is written with a value different from zero, and is allocated in the Java transient body heap 52, allocation is performed by the third RAM array pointer RA3 as described above.

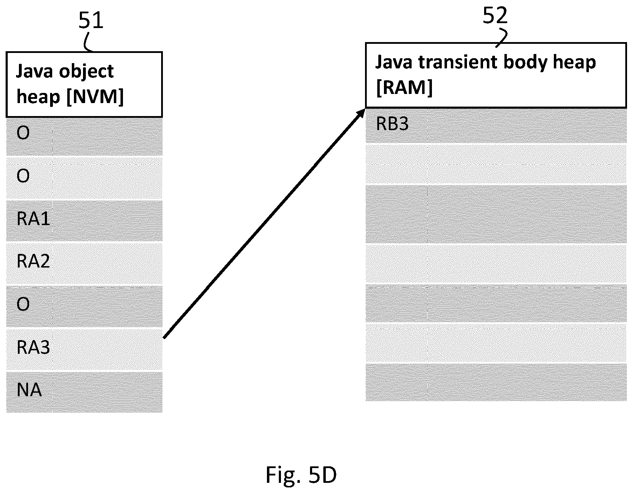

Figure 5D shows a fourth phase in which an update of the first array RB1 occurs, this resulting in the content of the first array RB1 being set with values all equal to zero. The first array RB1 is therefore deallocated, i.e. the corresponding RAM array pointer RA1 no longer points to the physical address (for instance the pointer has a null value as address, as detailed below) of the first array RB1. As a consequence the memory area previously allocated becomes just an area with all zero values.

Thus, in the prior art, the array pointer RA in the NVM 51 contains an indication of the array RB body size, and the body physical address, upon the application calling the method makeTransient...Array, the operative system assigning an area of the RAM memory, saving the address in the array pointer RA of the array RB body, the area remaining assigned to that array body RB until is deleted.

According to the embodiment described with reference to the phases of figures 5A-5D, instead, the array pointer RA in the object heap 51 contains:
- an indication of the array RB body size BS (BS1, BS2, BS3 for the three pointers RA1, RA2, RA3 in the example), which is the size of the area of the transient heap 52 in the RAM memory necessary to the array RB to contain the value or values of the array body RB, and
- a body logical address LA (LA1, LA2, LA3 for the three pointers RA1, RA2, RA3 in the example), which can be
   the address of the memory area assigned to the to the array body RB to contain the value of the array or
   the null (zero) value.
When the applet or application creates a transient array, specifically calling the method makeTransient...Array, the operative system does not assign an area of the transient heap 51 in the RAM memory to the array body RB. Instead, it asks the operating system to create the array pointer RA with the required body size BS, and to write a zero value in the array pointer RA as body logical address LA.

When the applet or application asks the operating system to write a value different from zero in any point of the array body RB, the operative system assigns an area of the RAM memory, with the size indicated in the array pointer RA body size B, to the array body RB and saves its address in the body logical address LA of the array pointer RA of the array body RB. That area of the memory remains assigned to that array body RB until is deleted (freeing the memory which was reserved to it both in the object heap 51 and transient heap 52). When the applet or application requests the operating system to fill with zeroes the array body RB, the operating system writes in the body logical address LA of the array pointer RA of the array RB a zero value and frees the RAM memory associated to the array body RB, making it available to other arrays that may need it.

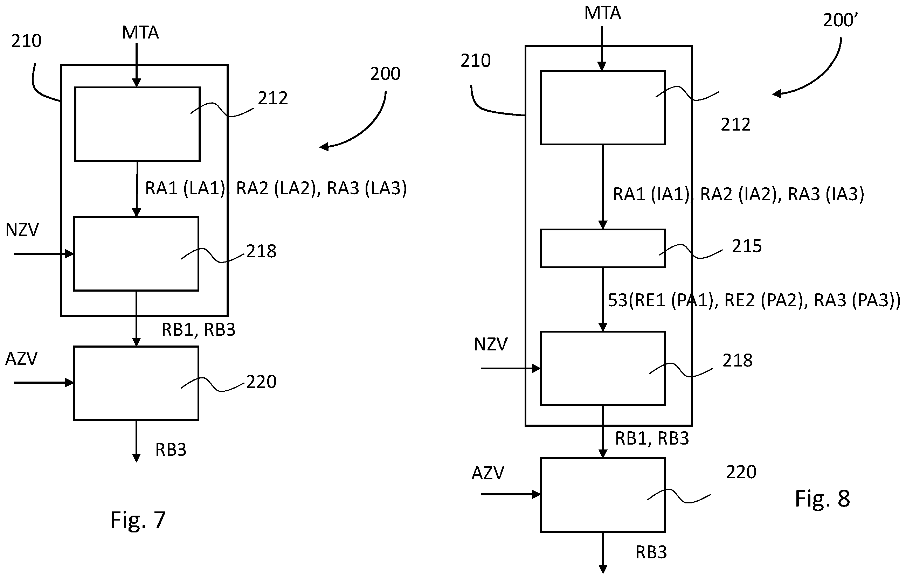

The method here described may comprise, as shown in figure 7, which shows an embodiment 200 of the method, a procedure 210 of creating transient arrays, e.g. RB1, RB2, RB3. Such procedure may be activated upon requests for instance of an applet or application calling a Java Card method making transient arrays MTA, for instance MakeTransient...Array.

As mentioned, such creating 210, which is in general performed by a software module in the non-volatile memory 52, not shown, generates or creates 212 the array pointers RA1, RA2, RA3 in the heap 52, such pointers comprising logical addresses LA1, LA2, LA3, defining a body of the length requested, BS1, BS2, BS3, by the application, however no actual array RB1, RB2, RB3 is actually stored, i.e. actually allocated in the RAM 52 at the time of the execution of this step 212.

It is here specified that creating 210 a transient array RB may be embodied by using a make transient array method - generically indicated as MakeTransient...Array (see also https://docs.oracle.com/javacard/3.0.5/api/javacard/fra mework/JCSystem.html), ... standing for the type of array, in the example here described reference to MakeTransientBytesArray is made -and creating the corresponding array pointer, or header, RA, as mentioned with logical LA rather than physical PA addresses.

As mentioned, here in the example a MakeTransientBytesArray is used, although makeTransientArray for each type of array can be used, e.g. Boolean, byte, short, Object. Here in the following with makeTransientXXXArray is indicated in a method allocating transient array as specified by Java Card API specification with a generic type XXX, i.e. XXX can be Boolean, byte, short, Object. Thus, in general, the method described comprises creating transient arrays by a Java Card method creating transient array, in particular one or more of:
- makeTransientBoolenArray
- makeTransientByteArray
- makeTransientShortArray
- makeTransientObjectArray.

In particular such creating 212 one or more array pointers RA comprises creating said one or more array pointers RA with a required body size BS and writing a null value as body logical address LA.

Then, upon writing at least a value different from zero, indicated with NZV, to a given transient array RB, performing an operation 218 of assigning then in said RAM memory 52 area memory only to transient arrays, RB1, RB3 in figure 5C, corresponding to said respective one or more array pointers RA, which comprise at least a value different from zero. A physical area in the RAM transient heap 52 is reserved to the corresponding transient array 52 by having the corresponding pointer RA pointing to the corresponding physical address or set of physical addressed in the RAM, for instance through a Memory Management Unit (MMU) mapping the logical address LA in a physical address PA.

In particular such assigning 218 then in the RAM memory 52 area memory only to transient arrays RB1, RB2, RB3, corresponding to said respective one or more array pointers RA, which comprise at least a value different from zero comprises, when writing a value different from zero in any point of an array body RB, assigning an area of the RAM memory 52, with the size indicated in the body size BS, to the corresponding transient array (RB) and saving its address in said logical address LA of the corresponding array pointer RA. This is then mapped to a physical address by the MMU.

Then, an operation of deallocating 220 in said RAM memory 52 transient arrays RB1 which values are all equal to zero may be performed, by modifying the corresponding pointer to point no longer to a physical address in the RAM 52.

In particular, comprising the operation of deallocating 220 comprises storing in the logical address LA either an address of the memory area assigned to the to the array body RB or a null value.
the deallocating comprising, when the transient array RB in the RAM memory 52 is filled with zeroes, i.e. contains all zero values AZV, writing in the indirect or logical address LA of the corresponding array pointer RA a zero value.

Of course, embodiment 200 is just exemplary, allocations 210 and deallocations 220 may occur in any sequence and number, provided that there is an array allocated to deallocate.

Thus, the method here described basically, with reference also to the flow diagram of figure 7 schematically illustrating an embodiment 200 of the method, it is a method of managing memory, such as memory 1084, in an integrated circuit card 108 using a Java Card platform, said integrated circuit card 108 comprising a non-volatile memory portion 51 and a RAM memory portion 52, said method comprising a procedure 210 for the allocation of one or more transient arrays in said RAM memory portion 52, said procedure comprising
creating 212 in a non-volatile memory heap 51 one or more array pointers RA1, RA2, RA3, corresponding to one or more transient arrays RB1, RB2, RB3 to be allocated, each array pointer RA1, RA2, RA3 comprising a transient array size BS and a transient array address, in this case logical address LA (in another embodiment an indirect address IA, as described below),
wherein
said creating operation 212 comprises
creating one or more array pointers RA comprising as transient array address an address, e.g. pointing indirectly to an area of the RAM memory portion in which the respective transient array RB1, RB2, RB3 is to be allocated,
said procedure 210 further comprising
assigning 218 then in said RAM memory 52 area memory only to transient arrays RB1, RB2, RB3, corresponding to said respective one or more array pointers RA, which comprise at least a value different from zero.

Then the method may comprise, in particular subsequently, deallocating (see also operation 220) in said RAM memory, i.e. Java transient body heap 52, transient arrays, such as RB1 which values are all equal to zero, i.e. clearing the value to zero, as described for instance with reference to figure 5D. Such clearing may be performed by the application managing the transient array, e.g. RB1.

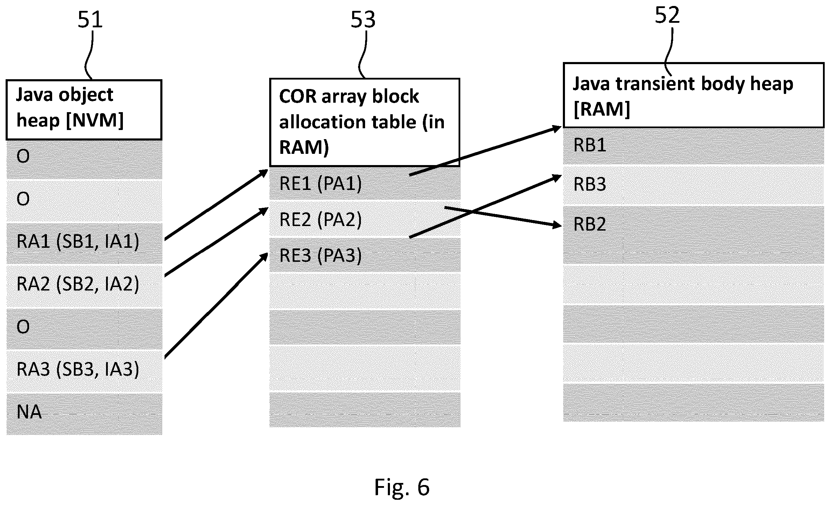

Since the RAM is more dynamic, having the header in non-volatile memory, such as Java object heap 51 (also of the RAM offset) is inefficient. To this regard, in figure 6 it is shown schematically an embodiment in which an indirection table 53 is introduced, stored in the RAM memory.

Specifically a COR (Clear On Reset) array block allocation table 53 is provided, which comprises body references RE, in the example a first body reference RE1, a second body reference RE2 and a third body reference RE3. The first RAM array pointer RA1 in this embodiment points to the body reference RE1, which is a header which in its turn point to the first array body RB1. The second array pointer RA1 and third array pointer RA2 in the same way point respectively to the second body RB2 and third body RB3 through second body reference RE2 and a third body reference RE3.

The method comprises thus providing an indirection table, i.e. COR (Clear On Reset) array block allocation table 53, stored in the RAM memory, comprising body references RE1, RE2, RE3 pointing to respective arrays RB1, RB2, RB3 and to which the RAM array pointers RA1, RA2, RA3 ordinately point, i.e. the array pointer RA points to the body reference RE which points at its respective array RB. The body reference RE embodies the pointer to the physical address in the RAM 52 of the corresponding array RB.

Thus, in variant embodiments, with the indirection table 53, the array pointer RA in the Java object heap 51 comprises
an indication of the array body RB size BS, which is the size of the area of RAM memory in the Java transient body heap 52 necessary to the array body RB to contain the values of the array body RB, and
a body indirect address IA, which is an address of the memory area which contains the indirection table 53 in the RAM memory, pointing to a corresponding reference address RE from which the physical address of the RAM memory, assigned to the array body RB to contain the value of the array or the zero value, can be retrieved (e.g., the physical address of the RAM memory is computed by adding a constant to the reference address RE or any other way).

In the array pointer RA is not saved the variable address of the body RB, but rather the fixed address of a memory portion of the RAM assigned to the array RB and designed to contain the address of the body array RB.

It is here specified that the transient array is defined in general as a logical address, also regarding the indirect address IA, since a logical address it is considered a virtual address which is mapped to a physical address through a third element. In the case of the logical address LA such element may be a Memory-Management Unit. In the case of the indirect address IA such element may correspond to the indirection table 53.

In figure 8 it is shown a flow diagram corresponding to the variant embodiment of figure 6.

With respect to the flow diagram of figure 7, between operations 212 and 218 is introduced an operation 215 of providing an indirection table 53, stored in the RAM memory 52, comprising reference addresses RE1, RE2, RE3 pointing to physical locations, PA1, PA2, PA3, of respective arrays RB1, RB2, RB3 in the RAM memory (52) and to which said RAM array pointers RA1, RA2, RA3 in the non-volatile memory, comprising a logic pointer ordinately point.

In particular, the array pointers of operation 212 comprises as transient array address an indirect address IA, instead of logical address LA, which comprises a null value or an address of the memory area containing said indirection table 53 in the RAM memory, comprising a corresponding reference address RE which in its turn contains the physical address of the RAM memory assigned to the array RB.

The array creation, i.e. creation of an array pointer RA, as mentioned, does not imply allocation, i.e. actual reservation of memory area for the array in RAM and so it is not limited by the available RAM.

Out of memory occurs when one of the created array RA is to be used, and so to be allocated in RAM, and the available memory in that moment is not enough.

Thus, to avoid the out of memory event at array use, the array creation shall be limited, by a heuristic, i.e. a set of rules.

An "extra memory" is thus provided by a check rule represented by way of example, by the following equation: 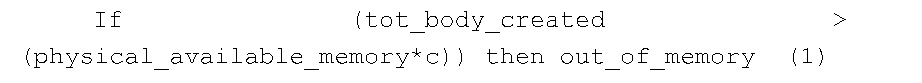 If (tot_body_created > (physical_available_memory*c)) then out_of_memory (1) where:
- tot_body_created indicates a memory value which is the sum of the size of all the created arrays (even if not allocated in the RAM at that moment), which correspond to all the executed makeTransientXXXArray in the device;
- physical_available_memory indicates a memory value which is the size of the physical memory in the RAM memory;
- c indicates a safety factor that if equal to one corresponds to the safest condition, which is also the most inefficient, equivalent to having all the memory is statically allocated, if greater than one corresponds to having some virtual extra memory available. As exemplified below, the safety factor c can be multiplied by the physical_available_memory or also added. Thus more in generale the physical_available_memory is increased by a safety amount which is function of the safety factor c;
- out_of_memory indicates the signalling of an out of memory event.

Thus the method in embodiments may comprise applying a checking rule (Equation (1), checking if a memory value, e.g. tot_body_created, representing the sum of the size of all the created arrays, e.g. RB1, RB2, RB3, is greater than a memory value representing the size of the total physical memory, e.g. physical_available_memory, in the RAM memory, increased by a safety amount which is function of the of a settable parameter value, e.g. safety factor c, in particular multiplied or summed by such settable parameter value, and in the affirmative signaling an out of memory event, e.g. out_of_memory.

Having an out of memory event at applet execution may cause problems. So, it is to be considered also the option that the check by applying the rule, i.e., equation (1), on the memory used by an application is performed at "applet selection" and, if an out of memory event occurs, it requests the failure of the selection.

Thus the method in embodiments may comprise performing said checking at an applet selection and, if an out of memory event, e.g., out_of_memory occurs, requesting the failure of the selection.

By way of example, Java Card supports OneShot objects, which are system objects that can be used by any Applet to perform cryptographic operation. The applet must use one object at a time, and it must get, use, and then release the object.

The value of tot_body_created by the OneShot objects may be for example in the platform here exemplified, 2128 bytes[this is true on our platform, it can be different on other platforms/OS], but the memory allocated in the RAM may be a maximum of 542 bytes, when the OneShot object with the biggest total size of arrays is used.

This means that 1586 bytes (= 2128 - 542) of memory are never used simultaneously with the remaining 542 bytes.

In this case, applying the check rule:
if (tot_body_created=2128> (physical_available_memory + 1586) ) then out_of_memory. The value 1586 represents the extra memory.

Here, the physicalavailable memory is increased by a safety amount which is function of the safety factor c in that a value of memory equal to safety factor c is summed to it. This corresponds of course to multiplying the physical_available_memory by a factor c'= (20,000+1586)/20,000), i.e. (physical_available_memory+c)/ physical_available_memory

By way of example, are here below represented a header structure (struct) according to the prior art and according to the method using the indirection table 53. As mentioned, in both cases, the header or pointer RA is allocated in the object heap 51 when it is requested to create the corresponding array body RB. As also shown, the solution here described provides that the array pointers RA so created are then not modified until the object is deleted.

Thus a prior art header struct may be as follows:

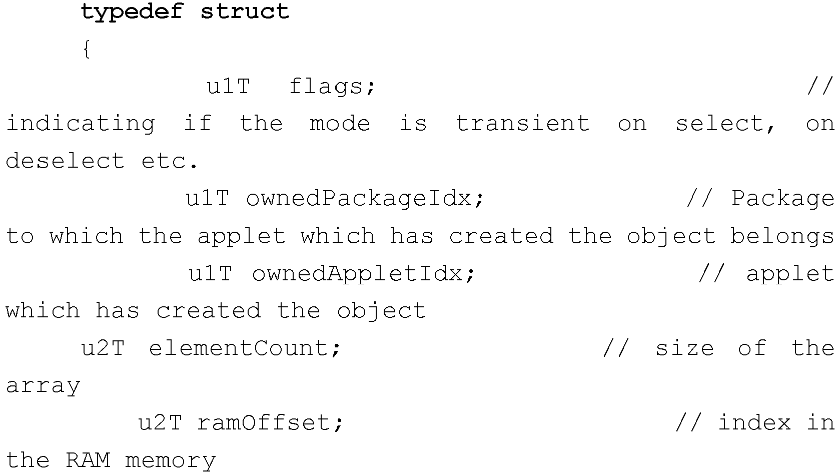

Therefore the header struct comprises a 'flags' variable indicating the mode (on select, deselect), a ownedPackageIdx variable indicating the Package to which the applet which has created the object belongs and a ownedAppletIdx variable indicating the applet which has created the object. Then the variable elementCount corresponds substantially to the field BS indicated above, i.e. stores the size of the array, and the ramOffset variable corresponds substantially to the physical address PA, represented by way of an offset address, i.e., storing an offset with respect to the beginning of the RAM (e.g. if the RAM is 32 kb in size goes from 0x20000 to 0x28000, an offset "0x500" then indicates that the physical space allocate to a certain transient array RB is at 0x20500; if the array is 0x80 bytes in size, occupies the physical space 0x20500->0x2057F).

Thus, the physical address of an array is 0x20000+headerPtr->ramoffset.

Using the indirection table 53 instead in the header struct, with respect to the prior header structs a index in the indirection table 53, e.g. bodycabatIdx, may be added in place of the offset.

Therefore, the struct corresponds substantially to the one of the prior art besides for a bodyCabatIdx variable, which embodies the indirect address IA. In particular the bodyCabatIdx index points to the array of the indirection table 53 which has a base address in the RAM 52 (e.g. begins at address 0x20000), the index itself indicates and offset inside the indirection table 53. Each entry in the indirection table 53 is for instance of two bytes and comprises an offset in the physical memory (the one indicated as ramOffset). The array which contains such elements (indirection table 53) is in the RAM.

Thus the physical address of an array is: 0x20000+cabat_array[headerPtr->bodyCabatIdx], i.e. the starting address plus the address written in the table 53 (reference RE) to which index, bodyCabatIdx, the pointer RA, headerPtr, points.

Such an indirection, as mentioned, is very useful as allocating/deallocating arrays from the RAM is performed in a more dynamical manner, thus optimization of such operations is very important. In the prior art, deallocation requires a writing operation in the flash. In the solution with the indirection table 53, writing operations are only in RAM since the indirection table 53 remains always the same, while the modified value is cabat_array[headerPtr->bodyCabatIdx] which resides in RAM, in a specific area memory storing the table 53.

Thus, the advantages of the solution described hereabove are clear.

The method for managing memory in an integrated circuit card using Java Card described is faster than the known methods without compromising reliability, and also interoperable, as no modifications to the application code take place.

The method described allows allocating volatile memory to the array only for as long as it is actually used, not from when it is created to when it is no longer reachable as per prior art solutions.

The method described allows to increase the amount of available memory since it keeps in memory only non-empty arrays.

Of course, without prejudice to the principle of the invention, the details of construction and the embodiments may vary widely with respect to what has been described and illustrated herein purely by way of example, without thereby departing from the scope of the present invention, as defined by the ensuing claims.

## Claims

1. A method of managing memory (1084) in an integrated circuit card (108) using a Java Card platform, said integrated circuit card (108) comprising a non-volatile memory portion (51) and a RAM memory portion (52), said method comprising a procedure (200) for allocating of one or more transient arrays in said RAM memory portion (52), said procedure comprising
creating (210) in a non-volatile memory heap (51) one or more array pointers (RA1, RA2, RA3), corresponding to one or more transient arrays (RB1, RB2, RB3) to be allocated, each array pointer (RA1, RA2, RA3) comprising a transient array size (BS) and a transient array address (LA; IA),
wherein
said creating (210) operation comprises
creating (212) one or more array pointers (RA) comprising as transient array address an address (LA; IA) pointing indirectly to an area of the RAM memory portion in which the respective transient array (RB1, RB2, RB3) is to be allocated, in particular a logical address (LA) or an indirect address (IA),
said procedure (200) further comprising
assigning (218) then in said RAM memory portion (52) area memory only to transient arrays (RB1, RB2, RB3), corresponding to said one or more respective array pointers (RA), which comprise at least a value different from zero.

2. A method according to claim 1, wherein said creating (212) one or more array pointers (RA) comprises creating said one or more array pointers (RA) with a required body size (BS) and writing a null value in the transient array address which is a body logical address (LA),
said assigning (218) then in said RAM memory (52) area memory only to transient arrays (RB1, RB2, RB3), corresponding to said one or more respective array pointers (RA), which comprise at least a value different from zero comprising, when writing a value different from zero in any point of an array body (RB), assigning an area of the RAM memory (52), with a size indicated in the required body size (BS), to the corresponding transient array (RB) and saving its address in said logical address (LA) of the corresponding array pointer (RA).

3. A method according to claim 1, comprising providing an indirection table (53), stored in the RAM memory portion (52), comprising reference addresses (RE1, RE2, RE3) pointing to physical locations of respective arrays (RB1, RB2, RB3) in the RAM memory (52) and to which said one or more RAM array pointers (RA1, RA2, RA3) in the non-volatile memory portion comprising a transient array address (IA), ordinately point.

4. A method according to claim 3, wherein said one or more array pointers comprise as transient array address an indirect address (IA) which comprises a null value or an address of a memory area containing said indirection table (53) in the RAM memory portion, comprising a corresponding reference address (RE) which in its turn contains the physical address (PA) of the RAM memory assigned to the array (RB).

5. A method according to any of the previous claims, comprising deallocating (220) in said RAM memory (52) transient arrays (RB1) which values are all equal to zero.

6. A method according to any of the previous claims, comprising storing in said logical address (LA) either an address of the memory area assigned to the array body (RB) or a null value.

7. A method according to claim 5 or 6, wherein said deallocating comprises, when the transient array (RB) in the RAM memory portion(52) is filled with zeroes writing in the logical address (LA) of the corresponding array pointer (RA) a zero value.

8. A method according to any of the previous claims, said procedure for the allocation of one or more transient arrays in said RAM memory portion (52) comprising performing a Java Card method making transient arrays.

9. A method according to claim 1, comprising applying a checking rule, checking if a memory values (tot_body_created) representing the sum of the size of all the arrays (RB1, RB2, RB3) corresponding to created array pointers (RA) is greater than a memory value representing the total physical memory (physical_available_memory) in the RAM memory portion (52) increased by a safety amount which is function of a settable parameter value (c), in particular multiplied or summed by such settable parameter value (c), and in the affirmative signalling an out of memory event (out_of_memory).

10. A method according to claim 9, comprising performing said checking upon an application selection and, if an out of memory event (out_of_memory) occurs, requesting a failure of said application selection.

11. An integrated circuit card (108), in particular an eUICC, configured to perform the operations of the method of managing memory (1084) according to any of claims 1 to 10.

## Patentansprüche

1. Verfahren zur Verwaltung des Speichers (1084) in einer Chipkarte (108) unter Verwendung einer Java Card-Plattform, wobei die Chipkarte (108) einen nichtflüchtigen Speicherabschnitt (51) und einen RAM-Speicherabschnitt (52) umfasst, wobei das Verfahren eine Prozedur (200) zur Zuweisung eines oder mehrerer vergänglicher Arrays in dem RAM-Speicherabschnitt (52) umfasst, wobei die Prozedur das Erstellen (210) in einem nichtflüchtigen Speicher-Heap (51) eines oder mehrerer Array-Zeiger (RA1, RA2, RA3) umfasst, die jeweils einem oder mehreren zuzuweisenden vergänglichen Arrays (RB1, RB2, RB3) entsprechen, wobei jeder Array-Zeiger (RA1, RA2, RA3) eine Größe des vergänglichen Arrays (BS) und eine Adresse des vergänglichen Arrays (LA; IA) umfasst,
wobei
die Erstellungsoperation (210) umfasst
Erstellen (212) eines oder mehrerer Array-Zeiger (RA), die als Adresse des vergänglichen Arrays eine Adresse (LA; IA) umfassen, die indirekt auf einen Bereich des RAM-Speicherabschnitts zeigt, in dem das jeweilige vergängliche Array (RB1, RB2, RB3) zugewiesen werden soll, insbesondere eine logische Adresse (LA) oder eine indirekte Adresse (IA),
wobei die Prozedur (200) weiter
Zuweisen (218) dann in dem RAM-Speicherabschnitt (52) eines Bereichsspeichers nur zu vergänglichen Arrays (RB1, RB2, RB3), die dem einen oder mehreren jeweiligen Array-Zeigern (RA) entsprechen, die mindestens einen Wert ungleich Null umfassen.

2. Verfahren nach Anspruch 1, wobei das Erstellen (212) eines oder mehrerer Array-Zeiger (RA) das Erstellen des einen oder mehrerer Array-Zeiger (RA) mit einer erforderlichen Körpergröße (BS) und das Schreiben eines Null-Werts in die vergängliche Array-Adresse, die eine logische Körperadresse (LA) ist,
das Zuweisen (218) dann in dem RAM-Speicher (52) eines Speicherbereichs nur zu vergänglichen Arrays (RB1, RB2, RB3), die dem einen oder mehreren jeweiligen Array-Zeigern (RA) entsprechen, die mindestens einen Wert ungleich Null umfassen, bei dem Schreiben eines Werts ungleich Null an einem beliebigen Punkt eines Array-Körpers (RB) Zuweisen eines Bereichs des RAM-Speichers (52) mit einer Größe, die in der erforderlichen Körpergröße (BS) angegeben ist, zu dem entsprechenden vergänglichen Array (RB) und Speichern seiner Adresse in der logischen Adresse (LA) des entsprechenden Array-Zeigers (RA) umfasst.

3. Verfahren nach Anspruch 1, umfassend das Bereitstellen einer Indirektionstabelle (53), die in dem RAM-Speicherbereich (52) gespeichert ist, umfassend Referenzadressen (RE1, RE2, RE3), die auf physische Ort der jeweiligen Arrays (RB1, RB2, RB3) in dem RAM-Speicher (52) zeigen und auf welche die eine oder mehrere RAM-Array-Zeiger (RA1, RA2, RA3) in dem nichtflüchtigen Speicherabschnitt, der eine vergängliche Array-Adresse (IA) umfasst, ordnungsgemäß verweisen.

4. Verfahren nach Anspruch 3, wobei der eine oder mehrere Array-Zeiger als vergängliche Array-Adresse eine indirekte Adresse (IA) umfassen, die einen Nullwert oder eine Adresse eines Speicherbereichs umfasst, der die Indirektionstabelle (53) in dem RAM-Speicherabschnitt enthält, eine entsprechende Referenzadresse (RE) umfassend, die ihrerseits die physische Adresse (PA) des dem Array (RB) zugewiesenen RAM-Speichers enthält.

5. Verfahren nach einem der vorstehenden Ansprüche, umfassend das Freigeben (220) in dem RAM-Speicher (52) von vergänglichen Arrays (RB1), deren Werte alle gleich Null sind.

6. Verfahren nach einem der vorstehenden Ansprüche, umfassend das Speichern in der logischen Adresse (LA) entweder einer Adresse des dem Array-Körper (RB) zugewiesenen Speicherbereichs oder eines Null-Werts.

7. Verfahren nach Anspruch 5 oder 6, wobei das Freigeben, wenn das vergängliche Array (RB) in dem RAM-Speicherabschnitt (52) mit Nullen gefüllt ist, Schreiben in der logischen Adresse (LA) des entsprechenden Array-Zeigers (RA) eines Null-Werts umfasst.

8. Verfahren nach einem der vorstehenden Ansprüche, wobei die Prozedur zu dem Zuweisen eines oder mehrerer vergänglicher Arrays in dem RAM-Speicherabschnitt (52) das Durchführen eines Java Card-Verfahrens zu dem Erstellen vergänglicher Arrays umfasst.

9. Verfahren nach Anspruch 1, umfassend das Anwenden einer Prüfregel, zu dem Prüfen, ob ein Speicherwert (tot_body_created), der die Summe der Größe aller Arrays (RB1, RB2, RB3) darstellt, die den erstellten Array-Zeigern (RA) entsprechen, größer ist als ein Speicherwert, der den gesamten physischen Speicher (physical_available_memory) in dem RAM-Speicherabschnitt (52) erhöht um einen Sicherheitsbetrag, der von einem einstellbaren Parameterwert (c) abhängig ist, insbesondere multipliziert oder addiert mit einem solchen einstellbaren Parameterwert (c), und in dem positiven Fall Signalisieren eines Out-of-Memory-Ereignisses (out_of_memory).

10. Verfahren nach Anspruch 9, umfassend das Durchführen der Prüfung bei einer Anwendungsauswahl und, falls ein Speicherüberlaufereignis (out_of_memory) auftritt, Anfordern einer Fehlermeldung für die Anwendungsauswahl.

11. Chipkarte (108), insbesondere eine eUICC, die ausgebildet ist, um die Operationen des Verfahrens zur Verwaltung des Speichers (1084) nach einem der Ansprüche 1 bis 10 auszuführen.

## Revendications

1. Procédé de gestion de mémoire (1084) dans une carte de circuit intégré (108) utilisant une plateforme Java Card, ladite carte de circuit intégré (108) comprenant une partie de mémoire non volatile (51) et une partie de mémoire RAM (52), ledit procédé comprenant une procédure (200) pour l'allocation d'une ou de plusieurs matrices transitoires dans ladite partie de mémoire RAM (52), ladite procédure comprenant :
la création (210) dans un ensemble de mémoire non volatile (51) d'un ou de plusieurs pointeurs de matrice (RA1, RA2, RA3), correspondant à une ou de plusieurs matrices transitoires (RB1, RB2, RB3) à allouer, chaque pointeur de matrice (RA1, RA2, RA3) comprenant une taille de matrice transitoire (BS) et une adresse de matrice transitoire (LA ; IA),
dans lequel ladite opération de création (210) comprend le fait de créer (212) un ou plusieurs pointeurs de matrice (RA) comprenant comme adresse de matrice transitoire une adresse (LA ; IA) pointant indirectement vers une zone de la partie de mémoire RAM dans laquelle la matrice transitoire respective (RB1, RB2, RB3) doit être allouée, en particulier une adresse logique (LA) ou une adresse indirecte (IA),
ladite procédure (200) comprenant en outre le fait d'attribuer (218) ensuite dans ladite partie de mémoire RAM (52) de la mémoire de zone uniquement aux matrices transitoires (RB1, RB2, RB3), correspondant auxdits un ou plusieurs pointeurs de matrice respectifs (RA), qui comprennent au moins une valeur différente de zéro.

2. Procédé selon la revendication 1, dans lequel ladite création (212) d'un ou de plusieurs pointeurs de matrice (RA) comprend le fait de créer lesdits un ou plusieurs pointeurs de matrice (RA) avec une taille de corps imposée (BS) et d'écrire une valeur nulle dans l'adresse de matrice transitoire qui est une adresse logique de corps (LA),
dans lequel ladite attribution (218) ensuite dans ladite partie de mémoire RAM (52) de mémoire de zone uniquement aux matrices transitoires (RB1, RB2, RB3), correspondant auxdits un ou plusieurs pointeurs de matrice respectifs (RA), qui comprennent au moins une valeur différente de zéro comprenant, lors de l'écriture d'une valeur différente de zéro en n'importe quel point d'un corps de matrice (RB), l'attribution d'une zone de la mémoire RAM (52), ayant une taille indiquée dans la taille de corps imposée (BS), à la matrice transitoire correspondante (RB) et la sauvegarde de son adresse dans ladite adresse logique (LA) du pointeur de matrice correspondant (RA).

3. Procédé selon la revendication 1, comprenant le fait de fournir un tableau d'adressage indirect (53), stocké dans la partie de mémoire RAM (52), comprenant des adresses de référence (RE1, RE2, RE3) pointant vers des emplacements physiques de matrices respectives (RB1, RB2, RB3) dans la mémoire RAM (52) et vers lesquelles lesdits un ou plusieurs pointeurs de matrice RAM (RA1, RA2, RA3) dans la partie de mémoire non volatile comprenant une adresse de matrice transitoire (IA) pointent de façon ordonnée.

4. Procédé selon la revendication 3, dans lequel lesdits un ou plusieurs pointeurs de matrice comprennent comme adresse de matrice transitoire une adresse indirecte (IA) qui comprend une valeur nulle ou une adresse d'une zone de mémoire contenant ledit tableau d'adressage indirect (53) dans la partie de mémoire RAM, comprenant une adresse de référence correspondante (RE) qui contient à son tour l'adresse physique (PA) de la mémoire RAM attribuée à la matrice (RB).

5. Procédé selon l'une quelconque des revendications précédentes, comprenant le fait de désaffecter (220) dans ladite mémoire RAM (52) les matrices transitoires (RB1) dont les valeurs sont toutes égales à zéro.

6. Procédé selon l'une quelconque des revendications précédentes, comprenant le fait de stocker dans ladite adresse logique (LA) soit une adresse de la zone de mémoire attribuée au corps de matrice (RB), soit une valeur nulle.

7. Procédé selon la revendication 5 ou 6, dans lequel ladite désaffectation comprend le fait, quand la matrice transitoire (RB) dans la partie de mémoire RAM (52) est remplie de zéros, d'écrire dans l'adresse logique (LA) du pointeur de matrice correspondant (RA) une valeur nulle.

8. Procédé selon l'une quelconque des revendications précédentes, dans lequel ladite procédure pour l'allocation d'une ou de plusieurs matrices transitoires dans ladite partie de mémoire RAM (52) comprend l'exécution d'un procédé Java Card qui crée des matrices transitoires.

9. Procédé selon la revendication 1, comprenant le fait d'appliquer une règle de contrôle qui vérifie si une valeur de mémoire (tot_body_created) représentant la somme de la taille de toutes les matrices (RB1, RB2, RB3) correspondant à des pointeurs de matrice créés (RA) est supérieure à une valeur de mémoire représentant la mémoire physique totale (physical_available_memory) dans la partie de mémoire RAM (52) augmentée d'une quantité de sécurité qui est fonction d'une valeur de paramètre réglable (c), en particulier multipliée par ou additionnée à cette valeur de paramètre réglable (c), et dans l'affirmative, signaler un évènement de dépassement de mémoire (out_of_memory).

10. Procédé selon la revendication 9, comprenant le fait d'effectuer ledit contrôle après une sélection d'application et, si un évènement de dépassement de mémoire (out_of_memory) se produit, demander un échec de ladite sélection d'application.

11. Carte de circuit intégré (108), en particulier carte eSIM, configurée pour réaliser les opérations du procédé de gestion de mémoire (1084) selon l'une quelconque des revendications 1 à 10.
